# EUROPÄISCHE PATENTSCHRIFT

(11) **EP 0 705 487 B1**
(45) Veröffentlichungstag und Bekanntmachung des Hinweises auf die Patenterteilung: **25.11.1998**
(21) Anmeldenummer: 94920464.8
(22) Anmeldetag: 27.06.1994
(51) Int. Cl.: H01Q 17/00

(54) **ANORDNUNG ZUR ABSORPTION VON ELEKTROMAGNETISCHEN WELLEN UND VERFAHREN ZUR HERSTELLUNG DIESER ANORDNUNG**
ARRANGEMENT FOR ABSORBING ELECTROMAGNETIC WAVES AND PROCESS FOR PRODUCING THE SAME
AGENCEMENT POUR L'ABSORPTION D'ONDES ELECTROMAGNETIQUES ET SON PROCEDE DE REALISATION

(30) Priorität: 25.06.1993 DE 4321165; 09.02.1994 DE 4404071
(43) Veröffentlichungstag der Anmeldung: 10.04.1996
(73) Patentinhaber: NIMTZ, Günter, D-50226 Frechen (DE); ENDERS, Achim, D-51061 Köln (DE)
(72) Erfinder: NIMTZ, Günter, D-50226 Frechen (DE); ENDERS, Achim, D-51061 Köln (DE)
(74) Vertreter: Hosbach, Hans Ulrich, Dipl.-Ing.
(86) Internationale Anmeldenummer: EP9402073
(87) Internationale Veröffentlichungsnummer: WO9500983

(56) Entgegenhaltungen:
- EP-A- 0 369 174
- EP-A- 0 370 421
- EP-A- 0 425 262
- EP-A- 0 473 515
- WO-A-91/05376
- WO-A-93/15530
- BE-A- 684 834
- GB-A- 776 158

## Beschreibung

Die Erfindung bezieht sich auf eine Anordnung zur breitbandigen Absorption von elektromagnetischer Wellen nach dem Oberbegriff des Anspruchs 1 und auf Verfahren zur Herstellung einer Anordnung für die breitbandige Absorption von elektromagnetischen Wellen nach dem Oberbegriff des Anspruchs 20, 21 bzw. 22.

Derartige Absorptionsanordnungen werden hauptsächlich als reflektionsfreie Verkleidungen von Räumen zur Prüfung der elektromagnetischen Verträglichkeit (EMV) verwendet.

Aus der EP-A 018 873 ist ein Absorptionselement für elektromagnetische Wellen bekannt, das aus einem dreidimensionalen Hohlkörper rechteckigen Querschnitts besteht. Die vier Seitenwände weisen jeweils ein dielektrisches Substrat und eine äußere Oberflächenbeschichtung auf, deren spezifischer Widerstand von einem zum anderen Ende der Seitenwand variiert, um elektromagnetische Wellen mit einer gewissen Bandbreite absorbieren zu können.

Bei einer anderen bekannten Absorber-Ausführung soll durch Vergrößerung der Schichtdicke und frequenzabhängig ausgelegte elektromagnetische Materialparameter eine wirksame Absorption von elektromagnetischen Wellen über einem bestimmten Frequenzbereich erreicht werden. Derartige Resonanzabsorber großer Schichtdicken haben entsprechend große Gewichte und bedingen relativ hohe Kosten und aufwendige baustatische Maßnahmen. Ihre Breitbandigkeit ist für heutige EMV-Testräume trotz des hohen Aufwandes nicht ausreichend.

Aus der EP-A 0 369 174 ist ein Absorptionskörper gemäß dem Oberbegriff des Anspruchs 1 bekannt. Der beschriebene, blockförmige Absorptionskörper enthält eine Sandwichanordnung aus Trägermaterialplatten, zwischen denen dünne Flächenwiderstandsschichten eingelagert sind. Als Flächenwiderstandsschichten kann z.B. eine Basismaterialschicht aus Glasvlies oder Papier verwendet werden, auf die eine Dispersion aus einem elektrisch leitendem Material, wie z.B. Ruß oder Graphit aufgetragen wird. Nachteilhaft bei diesen Absorptionsbläcken ist, daß durch das Auftragen einer Dispersion aus eletrisch leitendem Material eine Flächenwiderstandsschicht mit stark schwenkendem und uneinheitlichem Wiederstandswert geschaffen wird. Infolgedessen ist der erzielte Grad der Absorpiton und die Bandbreite unzureichend.

Aus der WO-A-91 05 376 ist ein Verfahren zur Herstellung einer Anordnung für die breitbandige Absorption gemäß der Gattung der Ansprüche 20 bis 22 bekannt. Es wird ein blockförmiger Absorptionskörper hergestellt, der eine Sandwichandordnung aus dicken Trägermaterialschichten enthält, zwischen denen dünne Flächenwiderstandsschichten eingelagert sind. Zur Erziehung eines Absorptionsgradienten in Richtung der einfallenden Wellen sind die Flächenwiderstandsschichten mit unterschiedlichen Materialien beschichtet oder mit Hilfe von Masken nur teilweise beschichtet. Derartige massive Absorptionselemente sind sehr platz- und materialaufwendig.

Die DE-AS 1 254 720 und die BE-A 684 834 beschreiben eine Anordnung, bei denen eine Anzahl von Hohlpyramiden aneinanderanstoßend an einer Wand angeordnet sind. Die Hohlpyramiden sind auf ihren Außen- und/oder Innenflächen mit einem leitfähigen Lack beschichtet. Die leitfähige Lackschicht wird entweder direkt auf den dreidimensionalen Trägerkörper aufgesprüht oder durch Tauchen des dreidimensionalen Körpers hergestellt.

Bei den bekannten Anordnungen sind entweder die betrieblichen Eigenschaften, beispielsweise die Bandbreite und der Grad der Absorption unzureichend oder die Herstellung der Absorptionsanordnung ist aufwendig und kostspielig.

Der Erfindung liegt deshalb die Aufgabe zugrunde, einen hohen Absorptionswirkungsgrad bei großer Bandbreite mit den Vorteilen einfacher und automatisierbarer Herstellung zu vereinigen.

Gelöst wird diese Aufgabe erfindungsgemäß durch die Anordnungsmerkmale gemäß Patentanspruch 1 bzw. verfahrensmäßig durch die Merkmale der Patentansprüche 20, 21 oder 22.

Durch die Erfindung gelingt es erstmalig, ein breitbandiges Spektrum von elektromagnetischer Strahlung mit Hilfe preiswert herstellbarer, leichtgewichtiger und dünner Flächenwiderstands-Schichtbauteile zu absorbieren. Dabei geht die Erfindung von der Erkenntnis aus, daß dünne Flächenwiderstandsbahnen selbst bei gleichmäßiger Flächenwiderstandsverteilung dann auf elektromagnetische Strahlung mit unterschiedlichen Wellenlängen absorbierend wirken, wenn sie in einem der elektromagnetischen Strahlung ausgesetzten Raum in bestimmter und/oder statistischer dreidimensionaler Geometrie angeordnet sind. Die Breitbandigkeit wird daher durch die besondere geometrische Anordnung der dünnen Flächenwiderstandsschichten im Raum erreicht. Die aufgestäubte oder niedergeschlagene Schicht aus elektrisch leitendem oder halbleitendem Material ermöglicht eine einheitliche und gleichmäßige spezifische Flächenwiderstandsverteilung. Die Absorptionseigenschaften lassen sich reproduzierbar einstellen. Da die Flächenwiderstandsschichten sehr dünn sind, haben sie vorteilhafterweise ein geringes Gewicht und sind dementsprechend kostengünstig herstellbar. Das Verhältnis von Absorberleistung/Gewichtseinheit der Anordnung ist besonders hoch, so daß die erfindungsgemäße Anordnung eine bisher unerreichte ökologische Verträglichkeit hat.

Ein wesentlicher Aspekt bei der Herstellung der erfindungsgemäßen Absorberanordnung besteht darin, daß eine beliebige Vielzahl von Absorptionselementen aus einer Flächenwiderstandsbahn hergestellt werden kann. Die Trägerbahn bzw. die nach der Beschichtung entstehende Flächenwiderstandsbahn kann beispielsweise eine Breite von 0,8 m und eine Länge von 10000 m haben. Die fertige Flächenwiderstandsbahn läßt sich am Ende des Bahn-Produktionsprozesses zu einem kompakten Bahnvorrat aufrollen. Die für die geometrischen Trägerstrukturen benötigten Flächenwiderstandsabschnitte werden dann aus der Materialrolle zugeschnitten, ausgestanzt oder in anderer geeigneter Weise geformt, auf der Trägerstruktur positioniert und fixiert. Dadurch entsteht die gewünschte räumliche, beispielsweise pyramidenförmige Absorberstruktur. Mit derartigen Absorberpyramiden wird der den elektromagnetischen Wellen ausgesetzte Raum (in Wand- und Deckenbereichen) ausgekleidet.

Eine wichtige Weiterbildung der Erfindung zeichnet sich dadurch aus, daß die Trägerschicht und/oder die Flächenwiderstandsschicht mit einer. Brandschutzschicht aus elektromagnetisch inertem Material, beispielsweise aus keramischem, mineralischem und/oder glasartigem Material versehen ist.

Vorzugsweise enthält die Flächenwiderstandsschicht eine leitfähige oder eine halbleitende Schicht aus einem Reinmetall, einer Metallegierung oder einem Halbleiter mit mindestens einem der Elemente Aluminium, Chrom, Eisen, Indium, Nickel, Antimon, Zinn, Tantal, Titan und Zink. Eines oder mehrere dieser Elemente werden vorzugsweise im Vakuum, ggf. unter Zusatz reaktiver Gase, wie z.B. Sauerstoff, auf die Trägerbahn aufgedampft oder gesputtert. Das Aufdampfverfahren ist an sich für die Herstellung von ca. 30 nm starken Aluminium-Beschichtungen auf Polymerfolien für Lebensmittelverpackungen bekannt und kann im Rahmen der Erfindung mit entsprechenden Kostenvorteilen eingesetzt werden.

Vorteilhafterweise enthält die Flächenwiderstandsschicht eine Trägerschicht aus. Polymerfolie oder Papier einer Dicke von 5 - 500 µm. Die Dicke der leitfähigen oder halbleitenden Schicht beträgt vorzugsweise 10 nm-200 nm.
In bevorzugter Ausführungsform verlaufen die Flächenwiderstandsschichten abschnittsweise unter verschiedenen Anstellwinkeln. Dies ist beispielsweise bei den oben erwähnten keil-, kegel- oder pyramidenförmigen Anordnungen der Fall. Alternativ können die Flächenwiderstandsschichten aber auch in mehreren unterschiedlichen Ebenen angeordnet, beispielsweise aufgespannt sein. Das Absorptionsspektrum wird in der zuletzt genannten Anordnung durch die unterschiedlichen und vorzugsweise parallelen Absorptionsebenen erreicht.

Eine alternative Anordnung, mit der vor allem stark profilierte Wandbereiche breitbandig absorbierend ausgekleidet werden können, ist in Weiterbildung der Erfindung dadurch gekennzeichnet, daß eine dreidimensionale Absorberstruktur aus einem Aufnahmebehälter mit einem Füllstoff besteht, der durch blattförmige vorzugsweise mehrfach geknickte bzw. geknüllte Flächenwiderstandsschichten gebildet ist. Stark profilierte Wandbereiche können dabei zumindest eine Seitenwand des Aufnahmebehälters bilden. Eine andere Seitenwand des Aufnahmebehälters kann durch eine einfache Bespannung gebildet sein, die durch die geknüllten Flächenwiderstandsbahnen kaum mechanisch belastet wird.

In einer alternativen Ausführungsform kann die Flächenwiderstandsschicht auch zu Volumen-Absorbermaterial weiterverarbeitet werden. Zerschneidet man die Flächenwiderstandsschicht z.B. in lange, schmale Streifen, so erhält man ein Volumen-Füllmaterial für Absorberanwendungen, das bei wesentlich weniger Materialbedarf dieselben Absorptionsleistungen aufweisen kann wie herkömmliche Absorbermaterialien, die mit leitfähigen Partikeln anstatt der Streifen dotiert sind. Die Anordnung der schmalen Streifen im Raumvolumen kann dabei sowohl in geordneten Strukturen, z.B. gitterartig, als auch statistisch verteilt wie z.B. bei einer Schüttung realisiert werden.

Ebenso vorteilhaft kann die Flächenwiderstandsschicht, z.B. eine beschichtete Polyäthylen-Folie, durch den einfachen Prozeß des thermischen Formens und Verschweißens weiterverarbeitet werden. Z.B. läßt sich so eine dickere, absorbierende Struktur mit Kammern und Hohlräumen realisieren, die ähnlich strukturiert sein kann wie die Luftkammern enthaltenden Verpackungsmaterialien aus Polymerfolien, die für einen stoßdämpfenden Transport von empfindlichen Gütern entwickelt worden sind und unter dem Namen Luftpolsterfolien bekannt sind.

Vorteilhafterweise kann eine besonders einfache Positionierung und Fixierung durch Druckdifferenzen wie in einer Traglufthalle erfolgen, sozusagen ein "Aufblasen" der Absorber, oder mittels eines Gestänges, ähnlich wie bei Zeltkonstruktionen.

Eine andere Ausführungsform der Erfindung ist dadurch gekennzeichnet, daß mehrere luft- oder gasgefüllte Hohlkörperstrukturen mit einer als Flächenwiderstandsschicht ausgebildeten Außenhaut eng zusammengefügt und/oder miteinander verbunden und auf wenigstens einer Wand des Raums angeordnet sind. Die als Absorptionselemente dienenden geschlossenen Hohlkörperstrukturen können unterschiedliche, vorzugsweise statistische Oberflächengestaltungen haben.

Andere vorteilhafte Weiterbildungen der Erfindung sind in den Unteransprüchen gekennzeichnet.

Im folgenden wird die Erfindung anhand von in der Zeichnung schematisch dargestellten Ausführungsbeispiele näher erläutert. In der Zeichnung zeigen:
- Fig. 1: schematisch eine Station zur Herstellung einer Flächenwiderstandsschicht aus einer Trägerbahn mit aufgestäubter Metallschicht;
- Fig. 2A: in stark vergrößertem Maßstab einen Abschnitt einer gemäß Figur 1 hergestellten Flächenwiderstandsschicht;
- Fig. 2B: in ebenfalls vergrößertem Maßstab einen Abschnitt einer Flächenwiderstandsschicht aus einem organischen Leiter;
- Fig. 3A: eine Teilansicht auf ein Ausführungsbeispiel einer Absorberstruktur mit pyramidenförmiger Geometrie;
- Fig. 3B: eine Absorberstruktur ähnlich derjenigen gemäß Fig. 3A mit anders ausgebildeter Trägerstruktur; und
- Fig. 4: eine schematische Seitenansicht auf das Innere eines elektromagnetischen Wellen ausgesetzten Raumes, dessen Seiten- und Deckwände praktisch vollständig mit pyramidenförmigen Absorberstrukturen gesetzt sind.

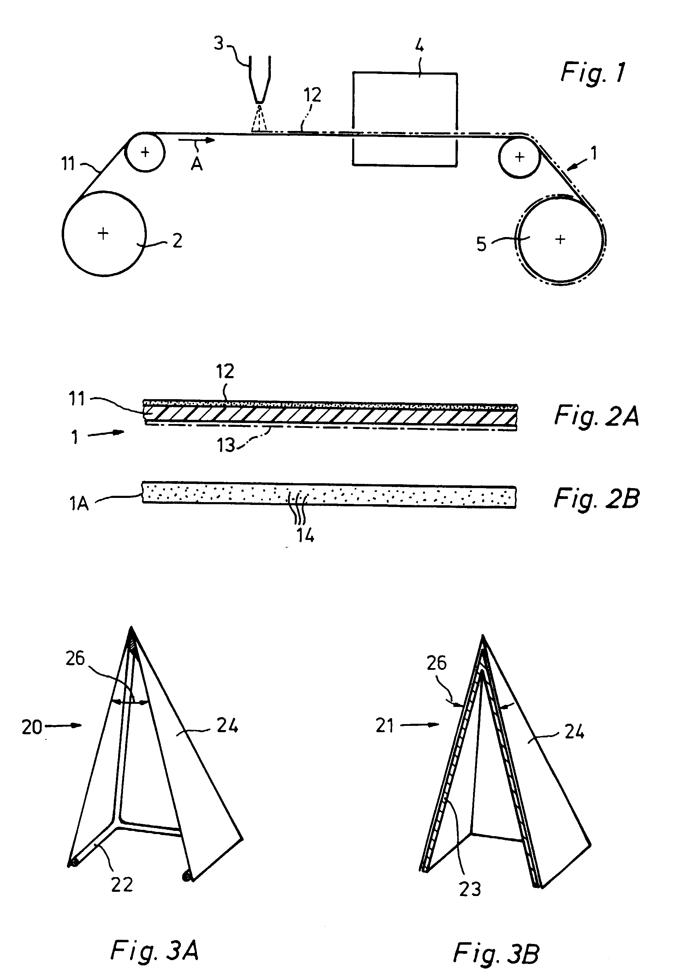

Anhand der Darstellung in Fig. 1 wird zunächst eine besonders wirtschaftliche Herstellung der aktiven Komponente der erfindungsgemäßen Absorptionsanordnung, nämlich einer Flächenwiderstandsschicht 1, beschrieben. Eine dünne Trägerbahn 11 aus Polymerfolie oder Papier einer Dicke von 5-500 µm wird von einer Vorratsrolle 2 abgezogen, umgelenkt und in Richtung des Pfeils A in eine Aufdampfzone unter eine Aufdampfanordnung 3 bewegt. In der Aufdampfzone wird in einer reaktiven Sauerstoffatmosphäre Aluminium mit oxidativen Anteilen aufgebracht. Eine Aluminiumschicht kann entweder in der dargestellten Weise einseitig oder auf beiden Seiten der Trägerbahn 11 aufgedampft werden. In dem beschriebenen Ausführungsbeispiel hat die Al-Schicht 12 eine Dicke von nur ca. 20-40 nm. Eine Lackversiegelung auf der Widerstandsschicht 12 kann in einer Heizkammer 4 getrocknet werden. Die Bahn 1 wird danach auf eine Aufwickelrolle 5 aufgewickelt. Der Wert des Flächenwiderstands kann durch Variation der Prozeßparameter auf einen Sollwert eingestellt werden, beispielsweise auf 150 Ohm.

Eine vergrößerte Darstellung eines Abschnitts der Flächenwiderstandsschicht 1 ist in Fig. 2A dargestellt. Wie zu sehen ist, kann die Trägerschicht 11 auch beidseitig mit Flächenwiderstände bildenden, dünnen, leitfähigen oder halbleitenden Schichten 12 und 13 belegt sein. Eine doppelseitige Beschichtung erhöht den Wirkungsgrad der aus der Flächenwiderstandsschicht 1 hergestellten Absorptionsstruktur, da die Absorptionsfähigkeit der Struktur auf beiden Schichtseiten den dort wirksamen elektromagnetischen Strahlungen angepaßt werden kann. Zusätzlich zu der oder als Schicht 13 kann eine Brandschutzschicht aus einem nicht oder schwer entflammbaren, vorzugsweise elektrisch und elektromagnetisch weitgehend inertem Material, z.B. aus Mineralwolle, Keramik und/oder Glas vorgesehen werden.

Anstelle des beschriebenen Aufdampfprozessses können, wie dem Fachmann bekannt ist, auch andere Beschichtungsverfahren, beispielsweise Aufstäuben (Sputtern) kontinuierliche Sieb- oder Walzendruckverfahren verwendet werden. Auf diese Weise kann beispielsweise auch eine aus einem organischen Leiter bestehende Schicht niedergeschlagen werden.

Eine alternative Ausführung der Flächenwiderstandsschicht ist in Fig. 2B schematisch dargestellt. Bei dieser alternativen Ausbildung besteht die Flächenwiderstandsschicht 1A aus einer Bahn vorzugsweise aus Kunststoff, in die leitende oder halbleitende feine Partikel 14 in einer für Absorptionszwecke geeigneten Verteilung eingebettet sind. Auch die leitenden oder halbleitenden Partikel können dabei aus Kunststoff bestehen. Es können beispielsweise intrinsisch leitende Polymere verwendet werden.

In Fig. 3A ist eine schematische Schnittansicht durch ein pyramidenförmiges Element 20 der erfindungsgemäßen Absorptionsanordnung dargestellt. Das Strukturelement 20 besteht aus einem Gestängegestell 22 mit einem Basisquadrat und vier die Pyramidenkanten bildenden Stangen aus elektrisch isolierendem Glasfasermaterial sowie einer Außenhaut 24. Letztere ist aus einem Zuschnitt aus dem Bahnmaterial 1 bzw. 1A hergestellt. Bei einem in der Praxis realisierten Ausführungsbeispiel wurde eine Flächenwiderstandsschicht 1 nach geeignetem Zuschneiden und thermischen Verschweißen der die Trägerbahn 11 bildenden Folie auf das Stangengestell 22 aufgesteckt und fixiert. Die das Absorptionselement 20 bildende Pyramide hatte eine Höhe von 1,50 mm und eine offene Grundfläche von 0,35 x 0,35 m². Wie leicht zu erkennen ist, lassen sich aus einem geeigneten Trägergestell und Flächenwiderstandszuschnitten zahlreiche geometrische Strukturen höchst einfach aufbauen. Die Scheitel sollten bei kegel-, keil- oder pyramidenförmigen Strukturen und Elementen relativ spitzwinklig sein und Scheitelwinkel 26 im Bereich zwischen 5 und 50°, vorzugsweise zwischen 8 und 25° haben.

Fig. 3B zeigt ein ähnliches Absorptionselement 21 wie dasjenige (20) gemäß Fig. 3A. Der einzige Unterschied besteht darin, daß die Außenhaut 24 der Pyramide nicht von einem Trägergestell 22 abgestützt, sondern auf einem pyramidenförmigen, selbsttragenden Hohlkörper 23 aus einem geeigneten Kunststoff oder aus Karton aufkaschiert ist. Die Außenhaut 24 kann aber bei einer in der Zeichnung nicht dargestellten anderen baulichen Alternative auch als Aufblasbauteil nach Art einer Traglufthalle ausgebildet sein. Dabei wird die die Absorptionsstruktur bildende Haut 24 einem leichten Differenzdruck ausgesetzt, der die Außenhaut 24 in ihrer pyramidenförmige Geometrie hält.

Anstelle der in den Figuren 3A und 3B dargestellten Pyramidenform kann auch eine kombinierte Kegel-Pyramidenstumpf form vorgesehen sein. Dabei ist die dem Scheitel nächstgelegene Spitze kegelförmig und die Grundebene quadratisch ausgebildet, um eine größere Absorptionsfläche mit entsprechenden Strukturelementen ohne oder mit nur minimalen Zwischenräumen abzudecken.

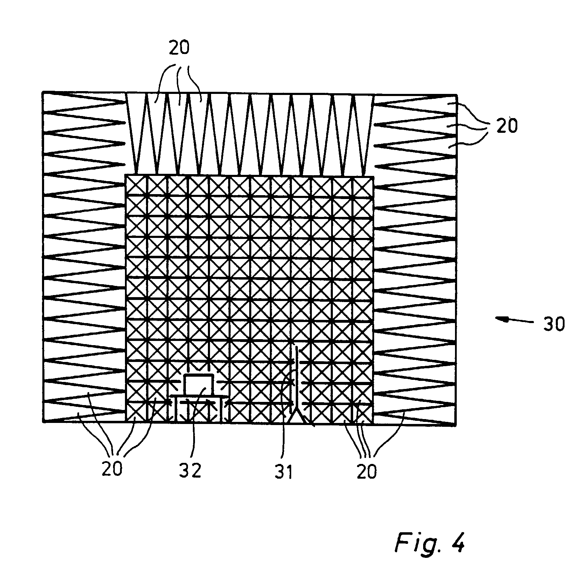

In Fig. 4 ist schematisch ein Vertikalschnitt durch einen EMV-Testraum 30 gezeigt, dessen Seitenwände und Decke mit pyramidenförmigen, praktisch lückenlos aneinander anstoßenden Absorberstrukturen 20 ausgekleidet sind. In dem Testraum 30 sind eine Antennenanordnung 31 und das zu testende Gerät 32 dargestellt. Wie zu sehen ist, sorgt die Auskleidung des Testraums 30 mit geometrisch verteilten Flächenwiderständen für eine praktisch totale, reflexionsfreie Absorption der Feldenergie, so daß optimale Testergebnisse gewährleistet sind.

Im Rahmen des Erfindungsgedankens sind zahlreiche Abwandlungen möglich. Die Wahl der Materialien der Träger- und Flächenwiderstände und die geometrischen Abmessungen der Bahnen und Strukturen können den Einsatzbedingungen angepaßt werden. Durchsichtige Flächenwiderstandsschichten ergeben sich beispielsweise bei Verwendung von Indium-Zinn-Oxid.

## Patentansprüche

1. Anordnung zur breitbandigen Absorption von elektromagnetischen Wellen, wobei mehrere Flächenwiderstandsschichten (1; 1A; 24) dreidimensional in einem den elektromagnetischen Wellen ausgesetzten Raum (30) angeordnet sind,
wobei die Flächenwiderstandsschicht (1) eine Trägerschicht (11) und wenigstens eine auf die Trägerschicht aufgebrachte Schicht (12) aus elektrisch leitendem oder halbleitendem Material aufweist,
wobei die Trägerschicht als mechanisch flexible Schicht mit einer Schichtdicke kleiner als 5 mm ausgebildet ist, und
wobei die Schicht aus elektrisch leitendem oder halbleitendem Material eine gleichmäßige und einheitliche Flächenwiderstandsverteilung hat,
**dadurch gekennzeichnet,**
daß die Schicht (12) aus elektrisch leitendem oder halbleitendem Material eine kontinuierlich oder quasi-kontinuierlich aufgestäubte oder niedergeschlagene Schicht einer Dicke von 5 nm bis 1000 nm ist.

2. Anordnung nach Anspruch 1, dadurch gekennzeichnet, daß die Flächenwiderstandsschichten (1; 1A) durch elektrisch leitende Teilchen auf und/oder in einer Kunststoff- oder Papierbahn gebildet sind.

3. Anordnung nach Anspruch 2, dadurch gekennzeichnet, daß die Flächenwiderstandsschicht (1) aus einer Kunststoff- oder Papierbahn (11) mit gleichmäßig auf wenigstens einer Seite aufgebrachter, elektrisch leitender oder halbleitender Schicht (12) besteht.

4. Anordnung nach einem der Ansprüche 1 bis 3, dadurch gekennzeichnet, daß die Flächenwiderstandswerte der Flächenwiderstandsschichten (1; 1A) zwischen 0,01 Ohm pro Quadrat und 20 kOhm pro Quadrat, vorzugsweise zwischen 10 Ohm pro Quadrat und 1 kOhm pro Quadrat liegen.

5. Anordnung nach einem der Ansprüche 1 bis 4, dadurch gekennzeichnet, daß die Flächenwiderstandsschicht (1) eine Trägerschicht aus Polymerfolie oder Papier einer Dicke von 5-500 µm enthält.

6. Anordnung nach einem der Ansprüche 1 bis 5, dadurch gekennzeichnet, daß die Flächenwiderstandsschicht eine leitfähige oder eine halbleitende Schicht aus einem Reinmetall, einer Metallegierung oder einem Halbleiter mit mindestens einem der Elemente Al, Cr, Fe, In, Ni, Sb, Sn, Ta, Ti und Zn enthält.

7. Anordnung nach Anspruch 6, dadurch gekennzeichnet, daß die leitfähige oder halbleitende Schicht (12) eine Dicke von 10 nm - 200 nm hat.

8. Anordnung nach einem der Ansprüche 1 bis 7, dadurch gekennzeichnet, daß wenigstens eine der Flächenwiderstands(1; 1A) und Trägerschichten (11) mit wenigstens einer geschlossenen Brandschutzschicht aus einem schwer entflammbaren Material versehen ist.

9. Anordnung nach Anspruch 8, dadurch gekennzeichnet, daß die Brandschutzschicht aus einem elektrisch bzw. elektromagnetisch im wesentlichen inerten Material, z.B. mineralischen oder keramischen Material und/oder Glas besteht.

10. Anordnung nach einem der Ansprüche 1 bis 9, dadurch gekennzeichnet, daß die Flächenwiderstandsschichten (1, 1A) in mehreren unterschiedlichen Ebenen angeordnet sind.

11. Anordnung nach einem der Ansprüche 1 bis 10, dadurch gekennzeichnet, daß die Flächenwiderstandsschichten (1, 1A) auf wenigstens einem keil-, kegel-, pyramiden-, oder stufenförmigen Träger (22, 23) angebracht sind.

12. Anordnung nach Anspruch 11, dadurch gekennzeichnet, daß der Träger aus einem ausreichend formstabilen Hohlkörper (23) besteht, auf dessen Mantelflächen passend zugeschnittende Abschnitte der Flächenwiderstandsschicht (24) befestigt sind.

13. Anordnung nach Anspruch 11, dadurch gekennzeichnet, daß der Träger aus einem Trägergerüst (22) besteht, das Streben zumindest an den Übergangskanten zwischen zwei benachbarten Ebenen von Flächenwiderstandsschichten, beispielsweise zwischen zwei Seitenflächen einer Pyramide aufweist.

14. Anordnung nach Anspruch 13, dadurch gekennzeichnet, daß die Flächenwiderstandsschichten (1; 1A) aus bahnförmigem flexiblen Material bestehen und die Außenflächen der Träger mit dem bahnförmigen Material bespannt sind.

15. Anordnung nach Anspruch 10, dadurch gekennzeichnet, daß mehrere Bahnen mit Flächenwiderstandsschichten- (1; 1A) in verschiedenen etwa parallelen Ebenen unter zumindest teilweiser Überlappung gehaltert sind.

16. Anordnung nach einem der Ansprüche 1 bis 9, dadurch gekennzeichnet, daß eine dreidimensionale Absorberstruktur aus einem Aufnahmebehälter mit einem Füllstoff besteht, der durch blattförmige, vorzugsweise mehrfach geknickte Flächenwiderstandsschichten gebildet ist.

17. Anordnung nach Anspruch 16, dadurch gekennzeichnet, daß die blattförmigen Flächenwiderstandsschichtabschnitte in willkürlicher Anordnung in den Hohlraum eingeordnet sind.

18. Anordnung nach einem der Ansprüche 1 bis 17, dadurch gekennzeichnet, daß die Seiten- und Deckwände des den elektromagnetischen Wellen ausgesetzten Raums (30) im wesentlichen vollständig mit dreidimensionalen, z.B. pyramidenförmigen Absorberelementen (20, 21) besetzt sind.

19. Anordnung nach einem der Ansprüche 12 bis 18, dadurch gekennzeichnet, daß die Absorberpyramiden (20; 21) spitzwinklige Scheitel mit Scheitelwinkeln im Bereich zwischen 5 und 50°, vorzugsweise 8 bis 25° haben.

20. Verfahren zur Herstellung einer Anordnung für die breitbandige Absorption von elektromagnetischen Wellen,
wobei eine Flächenwiderstandsbahn (1) durch kontinuierliches oder quasi-kontinuierliches Beschichten einer mechanisch flexiblen, dünnen Trägerbahn (11) mit einer dünnen, elektrisch leitfähigen Schicht (12) aus einem metallischen oder halbleitenden Material hergestellt wird; und
wobei aus der Flächenwiderstandsbahn (1) Zuschnitte für mehrere zweidimensionale Flächenwiderstandsabschnitte gebildet werden;
**dadurch gekennzeichnet,**
daß die elektrisch leitfähige Schicht in einer Dicke von 5nm bis 1000nm auf die Trägerbahn aufgetragen wird;
daß der Flächenwiderstandsbahn ein im wesentlichen gleichmäßiger und einheitlicher Flächenwiderstand gegeben wird; und
daß mit den Flächenwiderstandsabschnitten dreidimensionale Strukturen (22; 23) überzogen werden, um pyramiden-, keil-, kegel- oder stufenförmige Absorberelemente zu bilden.

21. Verfahren zur Herstellung einer Anordnung für die breitbandige Absorption von elektromagnetischen Wellen,
wobei eine Flächenwiderstandsbahn (1) durch kontinuierliches oder quasi-kontinuierliches Beschichten einer mechanisch flexiblen, dünne Trägerbahn (11) mit einer dünnen, elektrisch leitfähigen Schicht (12) aus einem metallischen oder halbleitenden Material hergestellt wird;
wobei aus der Flächenwiderstandsbahn (1) Zuschnitte für mehrere zweidimensionale Flächenwiderstandsabschnitte gebildet werden und danach mehrere zweidimensionale Flächenwiderstandsabschnitte im wesentlichen parallel zueinander angeordnet und festgelegt werden;
**dadurch gekennzeichnet,**
daß die elektrisch leitfähige Schicht in einer Dicke von 5nm bis 1000nm auf die Trägerbahn aufgetragen wird;
daß der Flächenwiderstandsbahn ein im wesentlichen gleichmäßiger und einheitlicher Flächenwiderstand gegeben wird; und
daß die parallel zueinander angeordneten Flächenwiderstandsabschnitte in gegenseitigem Abstand festgelegt werden.

22. Verfahren zur Herstellung einer Anordnung für die breitbandige Absorption von elektromagnetischen Wellen,
wobei eine Flächenwiderstandsbahn (1) durch kontinuierliches oder quasi-kontinuierliches Beschichten einer mechanisch flexiblen, dünne Trägerbahn (11) mit einer dünnen elektrisch leitfähigen Schicht (12) aus einem metallischen oder halbleitenden Material hergestellt wird, und
wobei die Flächenwiderstandsbahn in Abschnitte zerteilt wird;
**dadurch gekennzeichnet,**
daß die elektrisch leitfähige Schicht in einer Dicke von 5nm bis 1000nm auf die Trägerbahn aufgetragen wird;
daß der Flächenwiderstandsbahn ein im wesentlichen gleichmäßiger und einheitlicher Flächenwiderstand gegeben wird;
und daß eine Vielzahl der hergestellten Abschnitte als Füll- bzw. Zusatzstoffe für die Herstellung von Volumen-Absorbermaterial verwendet wird.

23. Verfahren nach einem der Ansprüche 20 bis 22, dadurch gekennzeichnet, daß die elektrisch leitfähige Schicht durch Niederschlagen aus der Dampfphase im Vakuum oder unter Zusatz reaktiver Gase erzeugt wird.

24. Verfahren nach Anspruch 20 bis 24, dadurch gekennzeichnet, daß die leitfähige Schicht (12) durch Aufstäuben im Vakuum oder unter Zusatz reaktiver Gase erzeugt wird.

25. Verfahren nach einem der Ansprüche 20 bis 24, dadurch gekennzeichnet, daß die leitfähige Schicht (12) mit oder ohne weiteren reaktiven Anteil erzeugt wird aus einem Reinmetall, einer Metallegierung oder einem Halbleiter unter Verwendung eines oder mehrerer der Elemente Al, Cr, Fe, In, Ni, Sb, Sn, Ta, Ti oder Zn.

26. Verfahren nach Anspruch 20, dadurch gekennzeichnet, daß mechanisch flexible Flächenwiderstandsabschnitte (24) pyramiden-, keil-, kegel- oder stufenförmig geformt und in dem den elektromagnetischen Wellen ausgesetzten Raum (30) positioniert werden und danach einem solchen Druckgradienten ausgesetzt werden, daß sie in ihrer gewünschten dreidimensionalen Form gehalten werden.

## Claims

1. System for the broad band absorption of electromagnetic waves, whereby a plurality of thin surface resistance layers (1;1A;24) are arranged three-dimensionally in a chamber (30) subjected to the electromagnetic waves, whereby the surface resistance layer (1) has a carrier layer (11) and at least one layer (12) of electrically conductive or semi-conductive material applied to the carrier layer, the carrier layer being constructed as a mechanically flexible layer with a thickness smaller than 5nm and the layer of electrically conductive or semi-conductive material having a uniform and homogeneous surface resistance distribution, characterised in that the layer (12) of electrically conductive or semi-conductive material is a continuously or quasi-continuously powder coated or deposited layer with a thickness of 5 nm to 1000 nm.

2. System as claimed in Claim 1, characterised in that the surface resistance layers (1;1A) are constituted by electrically conductive particles on and/or in a plastic or paper sheet.

3. System as claimed in Claim 2, characterised in that the surface resistance layer (1) comprises a plastic or paper sheet (11) with an electrically conductive or semi-conductive layer (12) applied uniformly to at least one side.

4. System as claimed in one of Claims 1 to 3, characterised in that the surface resistance values of the surface resistance layers (1;1A) are between 0.01 Ohm per square and 20 kOhm per square, preferably between 10 Ohm per square and 1 kOhm per square.

5. System as claimed in one of Claims 1 to 4, characterised in that the surface resistance layer (1) includes a carrier layer of polymer film or paper with a thickness of 5 - 500 µm.

6. System as claimed in one of Claims 1 to 5, characterised in that the surface resistance layer includes a conductive or a semi-conductive layer of a pure metal, a metal alloy or a semi-conductor with at least one of the elements Al, Cr, Fe, In, Ni, Sb, Sn, Ta, Ti and Zn.

7. System as claimed in Claim 6, characterised in that the conductive or semi-conductive layer (12) has a thickness of 10 nm - 200 nm.

8. System as claimed in one of Claims 1 to 7, characterised in that at least one of the surface resistance (1; 1A) and carrier layers (11) is provided with at least one closed fire protective layer of a flame-resistant material.

9. System as claimed in Claim 8, characterised in that the fire protective layer comprises an electrically or electromagnetically substantially inert material, e.g. mineral or ceramic material and/or glass.

10. System as claimed in one of Claims 1 to 9, characterised in that the surface resistance layers (1, 1A) are disposed in a plurality of different planes.

11. System as claimed in one of Claims 1 to 10, characterised in that the surface resistance layers (1, 1A) are applied to at least one wedge, cone, pyramid or step-shaped carrier (22, 23).

12. System as claimed in Claim 11, characterised in that the carrier comprises a sufficiently shape stable hollow body (23), secured to whose side surfaces are sections ofthe surface resistance layer (24) cut fittingly to size.

13. System as claimed in Claim 11, characterised in that the carrier comprises a carrier frame (22) which has struts at at least the transition edges between two adjacent planes of surface resistance layers, for instance between two side surfaces of a pyramid.

14. System as claimed in Claim 13, characterised in that the surface resistance layers (1; 1A) comprise flexible material in sheet form and the outer surfaces of the carrier are covered with the sheet material.

15. System as claimed in Claim 10, characterised in that a plurality of sheets with surface resistance layers (1; 1A) are secured in at least partially overlapping relationship in different approximately parallel planes.

16. System as claimed in one of Claims 1 to 9, characterised in that a three-dimensional absorber structure comprises a receiving container with a filler which is constituted by surface resistance layers in sheet form, preferably bent a number of times.

17. System as claimed in Claim 16, characterised in that the surface resistance layer sections in sheet form are disposed in an arbitrary arrangement in the hollow space.

18. System as claimed in one of Claims 1 to 17, characterised in that the side and top walls of the chamber (30) subjected to the electromagnetic waves are substantially completely occupied by three-dimensional, e.g. pyramidal, absorber elements (20, 21).

19. System as claimed in one of Claims 12 to 18, characterised in that the absorber pyramids (20; 21) have acute angled apexes with apex angles in the region between 5 and 50°, preferably 8 to 25°.

20. Method of manufacturing a system for the broad band absorption of electromagnetic waves, whereby a surface resistance sheet (1) is produced by continuously or quasi-continuously coating a mechanically flexible, thin carrier sheet (11) with a thin, electrically conductive layer (12) of a metallic or semiconductive material; and whereby blanks are formed from the surface resistance sheet (1) for a plurality of two-dimensional surface resistance sections; characterised in that the electrically conductive layer is applied to the carrier sheet in a thickness of 5 nm to 1000 nm; that the surface resistance sheet is given a substantially uniform and homogenous surface resistance; and that three-dimensional structures (22; 23) are covered with the surface resistance sections in order to form pyramid-, wedge-, cone- or step-shaped absorber elements.

21. Method of manufacturing a system for the broad band absorption of electromagnetic waves, whereby a surface resistance sheet (1) is produced by continuously or quasi-continuously coating a mechanically flexible. thin carrier sheet (11) with a thin, electrically conductive layer (12) of a metallic or semi-conductive material; whereby blanks are formed from the surface resistance sheet (1) for a plurality of two-dimensional surface resistance sections and thereafter a plurality of two-dimensional surface resistance sections are arranged substantially parallel to one another and fixed in position; characterised in that the electrically conductive layer is applied to the carrier sheet in a thickness of 5 nm to 1000 nm; that the surface resistance sheet is given a substantially uniform and homogenous surface resistance; and that the surface resistance sections, which are arranged parallel to one another, are fixed in position at a mutual spacing.

22. Method of manufacturing a system for the broad band absorption of electromagnetic waves, whereby a surface resistance sheet (1) is produced by continuously or quasi-continuously coating a mechanically flexible, thin carrier sheet (11) with a thin, electrically conductive layer (12) of a metallic or semi-conductive material, and whereby the surface resistance sheet is divided into sections; characterised in that the electrically conductive layer is applied to the carrier sheet in a thickness of 5 nm to 1000 nm; that the surface resistance sheet is given a substantially uniform and homogenous surface resistance; and that a plurality of the produced sections is used as filling or additive materials for the manufacture of bulk absorber material.

23. Method as claimed in one of Claims 20 to 22, characterised in that the electrically conductive layer is produced by deposition from the vapour phase in a vacuum or with the addition of reactive gases.

24. Method as claimed in Claims 20 to 23, characterised in that the conductive layer (12) is produced by powder coating in a vacuum or with the addition of reactive gases.

25. Method as claimed in one of Claims 20 to 24, characterised in that the conductive layer (12) is produced with or without a further reactive component from a pure metal, a metal alloy or a semi-conductor with the use of one or more of the elements Al, Cr, Fe, In, Ni, Sb, Sn, Ta, Ti or Zn.

26. Method as claimed in Claim 20, characterised in that mechanically flexible surface resistant sections (24) are formed into a pyramid-, wedge-, cone- or step-shape and positioned in the chamber (30) subjected to the electromagnetic waves and are thereafter subjected to such a pressure gradient that they are maintained in their desired three-dimensional shape.

## Revendications

1. Dispositif d'absorption à large bande d'ondes électromagnétiques, où plusieurs couches à résistance superficielle (1 ; 1A ; 24) sont placées tridimensionnellement dans une salle (30) exposée aux ondes électromagnétiques,
la couche à résistance superficielle (1) présentant une couche support (11) et au moins une couche (12) de matière conductrice ou semi-conductrice appliquée sur cette couche support,
la couche support étant une couche souple mécaniquement d'épaisseur inférieure à 5 mm, et
la couche de matière conductrice ou semi-conductrice ayant une distribution de résistance superficielle uniforme et unique,
caractérisé par le fait
que la couche (12) de matière conductrice ou semi-conductrice est une couche de 5 nm à 1000 nm d'épaisseur appliquée par pulvérisation ou déposée de façon continue ou quasi continue.

2. Dispositif selon la revendication 1, caractérisé par le fait que les couches à résistance superficielle (1 ; 1A) sont formées de particules conductrices sur et/ou dans une bande de plastique ou de papier.

3. Dispositif selon la revendication 2, caractérisé par le fait que la couche à résistance superficielle (1) est constituée d'une bande de plastique ou de papier (11) sur au moins une face de laquelle est appliquée uniformément une couche conductrice ou semi-conductrice (12).

4. Dispositif selon l'une des revendications 1 à 3, caractérisé par le fait que les résistances superficielles des couches à résistance superficielle (1 ; 1A) sont comprises entre 0,01 ohm par carré et 20 kilohms par carré, de préférence entre 10 ohms par carré et 1 kilohm par carré.

5. Dispositif selon l'une des revendications 1 à 4, caractérisé par le fait que la couche à résistance superficielle (1) contient une couche support en feuille de polymère ou en papier de 5 à 500µm d'épaisseur.

6. Dispositif selon l'une des revendications 1 à 5, caractérisé par le fait que la couche à résistance superficielle contient une couche conductrice ou une couche semi-conductrice constituée d'un métal pur, d'un alliage métallique ou d'un semi-conducteur contenant au moins un des éléments Al, Cr, Fe, In, Ni, Sb, Sn, Ta, Ti et Zn.

7. Dispositif selon la revendication 6, caractérisé par le fait que la couche conductrice ou semi-conductrice (12) a une épaisseur de 10 nm à 200 nm.

8. Dispositif selon l'une des revendications 1 à 7, caractérisé par le fait qu'au moins une des couches à résistance superficielle (1 ; 1A) et couches supports (11) est pourvue d'au moins une couche fermée de protection contre l'incendie en matière difficilement inflammable.

9. Dispositif selon la revendication 8, caractérisé par le fait que la couche de protection contre l'incendie est constituée d'une matière sensiblement inerte électriquement ou électromagnétiquement, par exemple de matière minérale ou céramique et/ou de verre.

10. Dispositif selon l'une des revendications 1 à 9, caractérisé par le fait que les couches à résistance superficielle (1, 1A) sont placées dans plusieurs plans différents.

11. Dispositif selon l'une des revendications 1 à 10, caractérisé par le fait que les couches à résistance superficielle (1, 1A) sont appliquées sur au moins un support (22, 23) en forme de coin, conique, pyramidal ou étagé.

12. Dispositif selon la revendication 11, caractérisé par le fait que le support est constitué d'un corps creux de forme suffisamment stable (23) sur les surfaces enveloppes duquel sont fixés des morceaux taillés de manière adaptée de la couche à résistance superficielle (24).

13. Dispositif selon la revendication 11, caractérisé par le fait que le support est constitué d'une ossature support (22) qui présente des jambes au moins sur les arêtes de jonction entre deux plans voisins de couches à résistance superficielle, par exemple entre deux faces latérales d'une pyramide.

14. Dispositif selon la revendication 13, caractérisé par le fait que les couches à résistance superficielle (1 ; 1A) sont constituées de matière souple en forme de bande et les surfaces extérieures des supports sont tendues de cette matière en forme de bande.

15. Dispositif selon la revendication 10, caractérisé par le fait que plusieurs bandes à couches à résistance superficielle (1 ; 1A) sont fixées dans différents plans à peu près parallèles avec recouvrement au moins partiel.

16. Dispositif selon l'une des revendications 1 à 9, caractérisé par le fait qu'une structure absorbante tridimensionnelle est constituée d'un récipient ayant une matière de remplissage qui est formée par des couches à résistance superficielle en forme de feuille et de préférence coudées plusieurs fois.

17. Dispositif selon la revendication 16, caractérisé par le fait que les morceaux de couche à résistance superficielle en forme de feuille sont placés dans la cavité dans une disposition arbitraire.

18. Dispositif selon l'une des revendications 1 à 17, caractérisé par le fait que les parois latérales et plafonds de la salle (30) exposée aux ondes électromagnétiques sont garnis pratiquement complètement d'éléments absorbants tridimensionnels, par exemple pyramidaux (20, 21).

19. Dispositif selon l'une des revendications 12 à 18, caractérisé par le fait que les pyramides absorbantes (20 ; 21) ont des sommets à angle aigu dont l'angle est compris entre 5 et 50°, de préférence entre 8 et 25°.

20. Procédé de fabrication d'un dispositif pour l'absorption à large bande d'ondes électromagnétiques,
dans lequel une bande à résistance superficielle (1) est fabriquée par revêtement continu ou quasi continu d'une bande support mince et mécaniquement souple (11) d'une mince couche conductrice (12) d'une matière métallique ou semi-conductrice, et
dans la bande à résistance superficielle (1) sont faites des découpes pour plusieurs morceaux bidimensionnels à résistance superficielle,
caractérisé par le fait
que la couche conductrice est appliquée sur la bande support en une épaisseur de 5 nm à 1000 nm,
qu'à la bande à résistance superficielle est donnée une résistance superficielle pratiquement uniforme et unique, et
que des structures tridimensionnelles (22 ; 23) sont recouvertes des morceaux à résistance superficielle pour la formation d'éléments absorbants pyramidaux, en forme de coin, coniques ou étagés.

21. Procédé de fabrication d'un dispositif pour l'absorption à large bande d'ondes électromagnétiques,
dans lequel une bande à résistance superficielle (1) est fabriquée par revêtement continu ou quasi continu d'une bande support mince et mécaniquement souple (11) d'une mince couche conductrice (12) d'une matière métallique ou semi-conductrice,
dans la bande à résistance superficielle (1) sont faites des découpes pour plusieurs morceaux bidimensionnels à résistance superficielle, et ensuite, plusieurs morceaux bidimensionnels à résistance superficielle sont placés et fixés sensiblement parallèlement les uns aux autres,
caractérisé par le fait
que la couche conductrice est appliquée sur la bande support en une épaisseur de 5 nm à 1000 nm,
qu'à la bande à résistance superficielle est donnée une résistance superficielle pratiquement uniforme et unique, et
que les morceaux à résistance superficielle placés parallèlement les uns aux autres sont fixés à distance les uns des autres.

22. Procédé de fabrication d'un dispositif pour l'absorption à large bande d'ondes électromagnétiques,
dans lequel une bande à résistance superficielle (1) est fabriquée par revêtement continu ou quasi continu d'une bande support mince et mécaniquement souple (11) d'une mince couche conductrice (12) d'une matière métallique ou semi-conductrice, et
la bande à résistance superficielle est divisée en morceaux,
caractérisé par le fait
que la couche conductrice est appliquée sur la bande support en une épaisseur de 5 nm à 1000 nm,
qu'à la bande à résistance superficielle est donnée une résistance superficielle pratiquement uniforme et unique,
et qu'un grand nombre des morceaux produits sont utilisés comme matières de remplissage ou additionnelles pour la production de matériau absorbant en volume.

23. Procédé selon l'une des revendications 20 à 22, caractérisé par le fait que la couche conductrice est produite par dépôt en phase vapeur sous vide ou avec addition de gaz réactifs.

24. Procédé selon les revendications 20 à 24, caractérisé par le fait que la couche conductrice (12) est produite par pulvérisation sous vide ou avec addition de gaz réactifs.

25. Procédé selon l'une des revendications 20 à 24, caractérisé par le fait que la couche conductrice (12) est produite avec ou sans partie supplémentaire réactive à partir d'un métal pur, d'un alliage métallique ou d'un semi-conducteur avec utilisation d'un ou de plusieurs des éléments Al, Cr, Fe, In, Ni, Sb, Sn, Ta, Ti et Zn.

26. Procédé selon la revendication 20, caractérisé par le fait que des morceaux à résistance superficielle mécaniquement souples (24) sont mis en forme de pyramide, de coin, de cône ou étagée et placés dans la salle (30) exposée aux ondes électromagnétiques et ensuite soumis à un gradient de pression tel qu'ils soient maintenus dans la forme tridimensionnelle désirée.
